# DEMANDE DE BREVET EUROPEEN

(11) **EP 2 696 501 A1**
(43) Date de publication de la demande: **12.02.2014**
(21) Numéro de dépôt: 13176678.4
(22) Date de dépôt: 16.07.2013
(51) Int. Cl.: H03K 7/08, H01H 47/32

(54) **Procédé de commande d'un contacteur électromagnétique et contacteur électromagnétique mettant en oeuvre un tel procédé**

(30) Priorité: 08.08.2012 FR 1257696
(71) Demandeur: ABB France, 91978 Courtaboeuf Cedex (FR)
(72) Inventeur: Hamond, Christophe, 69510 Messimy (FR)
(74) Mandataire: Verriest, Philippe

(57) **Abrégé**

La présente invention concerne un procédé de commande d'un contacteur électromagnétique. Elle concerne aussi un contacteur électromagnétique mettant en oeuvre un tel procédé.

Le procédé consiste à alimenter l'électroaimant (9) du contacteur (4) par un signal d'alimentation à modulation de largeur d'impulsions (MLI) et présentant une fréquence nominale (Fch), le procédé consistant également à faire varier la période (T) sur au moins une partie des impulsions de la modulation de façon à réduire les perturbations électromagnétiques conduites, la variation de la période (T) étant choisie de façon à ce que la fréquence (F) du signal d'alimentation reste comprise dans une bande de fréquences donnée (BF) comportant la fréquence nominale (Fch).

## Description

La présente invention concerne un procédé de commande d'un contacteur électromagnétique. Elle concerne aussi un contacteur électromagnétique mettant en oeuvre un tel procédé.

Un contacteur électromagnétique comporte un électroaimant qui est alimenté à travers un circuit de commande de manière à créer une force électromagnétique actionnant le déplacement d'une partie mobile ou noyau, qui comporte des contacts destinés à fermer ou ouvrir un circuit électrique.

Le signal de commande dudit électroaimant peut être de type Modulation à Largeur d'Impulsions ou MLI, de période T et de largeur d'impulsion τ. On note rapport cyclique le rapport τ/T. Il est connu pour une fréquence donnée du signal en modulation de largeur d'impulsions MLI et une forme d'onde donnée, de faire varier le rapport cyclique τ/T afin de moduler l'énergie transférée.

Dans cette situation, on s'est aperçu que, lorsque le circuit de commande travaillait en commutation de cette façon, des parasites (harmoniques) étaient générés, principalement par les commutations au niveau de la charge tant par conduction sur les lignes conductrices d'alimentation, que par rayonnement, situation défavorable qui est renforcée par la charge électrique du contacteur essentiellement composée d'un solénoïde ou l'électroaimant.

La présente invention a pour objet de résoudre tout ou partie des inconvénients mentionnés ci-dessus.

A cet effet, la présente invention concerne un procédé de commande d'un contacteur électromagnétique comprenant les étapes consistant à :
- alimenter l'électroaimant du contacteur par un signal d'alimentation à modulation de largeur d'impulsions et présentant une fréquence nominale,
- faire varier la période sur au moins une partie des impulsions de la modulation de façon à réduire les perturbations électromagnétiques conduites,

la variation de la période étant choisie de façon à ce que la fréquence du signal d'alimentation reste comprise dans une bande de fréquences donnée comportant la fréquence nominale.

Selon un aspect du procédé, on fait varier la largeur d'impulsion du signal d'alimentation.

Selon un aspect du procédé, la variation de la période des impulsions est déterminée de manière aléatoire.

Selon un aspect du procédé, la variation de la période des impulsions est déterminée par une fonction déterministe.

Selon un aspect du procédé, la fonction est linéaire ou linéaire par morceaux.

Selon un autre aspect du procédé, la variation de la période des impulsions est déterminée de manière pseudo-aléatoire.

Selon un aspect du procédé, les variations de la période sont cycliques.

Selon un aspect du procédé, la variation de la période des impulsions est appliquée de façon à :
- conserver une même période sur une première pluralité de périodes ;
- modifier la valeur de la période pour une seconde pluralité de périodes.

Selon un aspect du procédé, la variation de la période des impulsions est appliquée de façon continue à chaque période.

Selon un aspect du procédé, on prend en compte un gabarit définissant une limite de perturbation acceptable par valeur de fréquence dans la bande de fréquence 150kHz - 30MHz.

Selon un aspect du procédé, la fréquence du signal d'alimentation présente une variation comprise à titre d'exemple entre 0 et deux fois la fréquence nominale de modulation Fch, ou selon un autre exemple entre 0,5 fois et 1,5 fois la fréquence nominale de modulation Fch...

La présente invention a également pour objet un contacteur électromagnétique comportant un circuit de commande agencé pour mettre en oeuvre les étapes d'un procédé tel que décrit précédemment.

Selon un aspect de l'invention, le circuit de commande comprend un dispositif de modulation MLI agencé pour déterminer une variation de la fréquence à partir de la fréquence nominale.

Selon un aspect de l'invention, le modulateur comprend des moyens de génération de valeurs aléatoires ou pseudoaléatoires.

D'autres caractéristiques et avantages de la présente invention seront mieux compris à l'aide de la description et des figures qui sont :
- la Figure 1 : un schéma d'un contacteur selon l'invention ;
- la Figure 2 : un graphe d'une commande MLI d'un l'électroaimant du contacteur selon l'état de la technique ;
- la Figure 3 : un graphe de mesure des parasites générés par le graphe de commande de la Figure 2 ;
- la Figure 4 : un schéma bloc d'une commande MLI de l'électroaimant d'un contacteur selon un mode de réalisation de l'invention ;
- la Figure 5 : un graphe de mesure d'une commande MLI del'électroaimant du contacteur du mode de réalisation de la Figure 4 ; et
- la Figure 6 : un graphe des parasites générés par le schéma de commande des Figures 4 et 5.

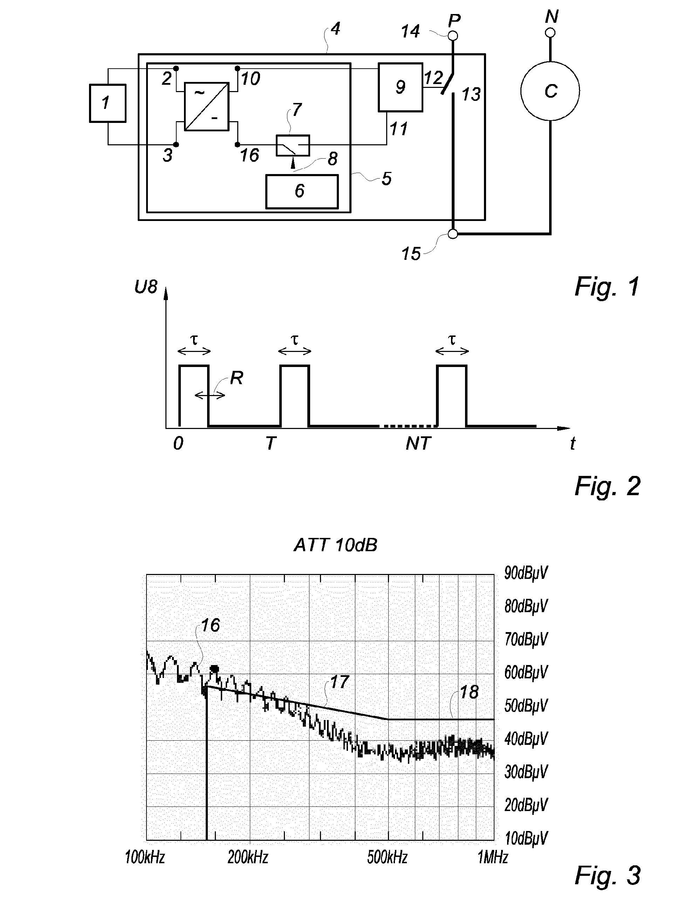

A la Figure 1, on a représenté un schéma d'un contacteur selon l'invention. Le contacteur 4 comporte principalement un interrupteur 13 ou organe de contact disposé dans un circuit de puissance et un circuit de commande 5 disposé sur une source d'alimentation de commande 1. Le circuit de commande 5 comporte un noyau 12 ou partie mobile et un électroaimant 9. Le noyau 12 manoeuvre un levier de l'interrupteur 13.

Le circuit de commande 5 est connecté à une source d'alimentation de commande 1. La source 1 débite un courant lorsqu'une commande est émise depuis la source d'alimentation de commande 1 vers le circuit de commande 5 du contacteur 4. A cet effet, le circuit de commande 5 du contacteur 4 comporte deux bornes de connexion 2 et 3 à la source d'alimentation de commande 1.

Pour une utilisation d'une source d'alimentation alternative ou continue, un redresseur est connecté entre une borne 2 et une première borne 10, et entre la borne 3 et une seconde borne 16.

La borne de connexion 16 est connectée à travers le circuit de commande 5 à une seconde borne 11 de polarisation de l'électroaimant 9 du contacteur 4 par le moyen d'un interrupteur électronique 7 tel qu'un transistor MOS ou bipolaire de puissance. L'interrupteur électronique 7 est connecté par le biais d'une borne de commande 8, comme la grille d'un transistor MOS ou une base d'un bipolaire de puissance, à un modulateur MLI 6 qui génère un signal carré de rapport cyclique déterminé en fonction de l'énergie que l'on désire transférer à l'électroaimant 9 pour obtenir une manoeuvre et/ou un maintien correct du noyau 12.

Le noyau 12 manoeuvre le levier mobile de l'interrupteur 13. L'interrupteur 13 est connecté entre deux bornes 14 et 15 du contacteur qui sont destinées à être connectées à un circuit de puissance à commander par le contacteur. Un tel circuit de puissance peut comporter une alimentation alternative monophasée entre une phase P et un neutre N et comporter une charge C comme un moteur électrique.

A la Figure 2, on a représenté un graphe d'une commande en modulation de largeurs d'impulsions MLI de fermeture du contacteur selon l'état de la technique. Le graphe représente l'évolution du signal de commande U8 appliqué sur l'électrode de commande de l'interrupteur électronique 7. Le signal carré est composé d'une répétition de N créneaux d'une durée τ et d'une période T qui présente un rapport cyclique τ/T déterminé en fonction d'un programme de polarisation de l'électroaimant. Le créneau haut représente par exemple la durée de conduction de l'interrupteur électronique 7 quand sa borne de commande 8 est connectée au modulateur MLI 6. Il en résulte une certaine énergie transmise en moyenne pendant la séquence des N créneaux à l'électroaimant 9. L'énergie transmise à l'électroaimant 9 peut prendre par exemple une valeur réduite pendant une durée de maintien de fermeture de l'interrupteur 13, de façon à réduire l'échauffement de l'électroaimant 9. Dans ce cas, la durée de conduction τ peut être augmentée ou réduite en ajustant le moment du front descendant R de la forme d'onde de la figure 2.

Selon l'état de la technique, le modulateur MLI 6 comporte un oscillateur produisant une fréquence nominale Fch qui détermine la période T des créneaux, un registre contenant une valeur représentative de la durée τ de conduction, un compteur chargé à la valeur représentative de la durée de conduction et un oscillateur à fréquence plus élevée que la fréquence nominale Fch. Lorsque le compteur a atteint la valeur du registre, une bascule fait retomber à zéro le signal de conduction. D'autres techniques sont connues qui mettent en oeuvre des moyens analogiques à base de rampes et de comparaison de tensions.

Cependant, la présence d'un signal crénelé U8 sur la borne de commande 8 de l'interrupteur électronique 7 génère une grande quantité de parasites qui peuvent venir perturber le fonctionnement des appareils électriques et électroniques disposés au voisinage du contacteur 4.

Ainsi, à la Figure 3, on a représenté l'émission sur les lignes d'alimentation des parasites générés par un contacteur sous commande MLI utilisant la loi de commande illustrée sur la figure 2. On a représenté l'amplitude 16 des harmoniques de courant en fonction de la fréquence sur une échelle semi-logarithmique. On a aussi représenté un gabarit limite de l'amplitude des parasites générés qui comporte une rampe descendante 17 de 150 kHz à 500 kHz puis une valeur constante 18 au-delà de 500 kHz.

Selon l'invention, afin de ne pas dépasser le gabarit limite des amplitudes de parasite, le modulateur 6 est agencé pour faire varier la période T sur au moins une partie des impulsions de la modulation de façon à réduire les perturbations électromagnétiques conduites, la variation de la période T étant choisie de façon à ce que la fréquence F du signal d'alimentation reste comprise dans une bande de fréquences donnée BF comportant la fréquence nominale Fch.

Selon un mode de mise en oeuvre, la variation de fréquence des impulsions est déterminée de manière aléatoire autour de la fréquence nominale Fch de modulation MLI, les paramètres de la loi de variation étant déterminés de façon à réduire l'amplitude des parasites dans le spectre de fréquences. Le spectre de fréquences est ici déterminé dans une bande de 150 kHz à 30 MHz.

Dans le procédé de l'invention, la fréquence nominale est déterminée pour une séquence de N créneaux de mise en conduction de l'interrupteur électronique 7 de façon à déterminer une énergie transmise à l'électroaimant 9 selon un schéma d'alimentation désiré. Mais, au lieu de conserver constante cette fréquence nominale Fch de modulation MLI, pendant la durée des N impulsions, la période T=1/Fch de chaque impulsion de la séquence varie, d'une valeur variable +a ou -b. Selon l'invention, la variation aléatoire de fréquence F, ou de période, est déterminée de façon à produire un étalement du spectre généré par la commutation de l'interrupteur de puissance 7. τ varie également afin de conserver le rapport τ/T constant.

La période T et/ou de la largeur d'impulsion τ peuvent être constantes sur une première pluralité de périodes avant d'être modifiées sur une seconde pluralité de périodes.

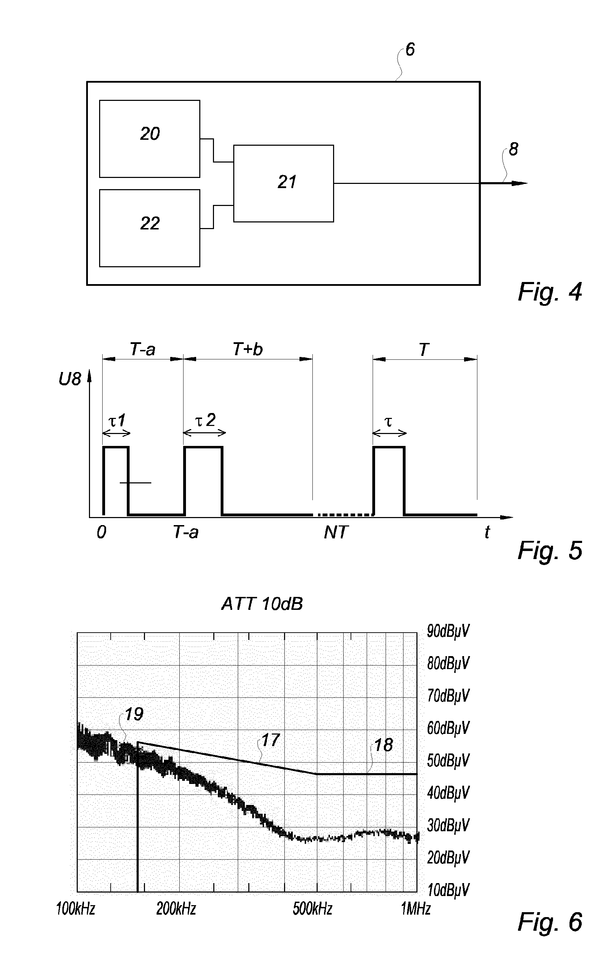

Le modulateur MLI 6 est agencé pour, comme représenté à la figure 4 :
- déterminer 20 la fréquence nominale Fch adaptée qui peut notamment prendre une valeur prédéfinie stockée dans une mémoire du modulateur ;
- déterminer 22 une variation de la fréquence F à partir de la fréquence nominale Fch ;
- appliquer 21 les variations de la fréquence F pour générer une récurrence MLI sur une borne de commande 8 de l'interrupteur électronique 7 (Figure 1).

Lorsque la variation de la fréquence F est entièrement déterminée, par exemple sous forme d'une ou plusieurs séquences adaptées à réduire l'amplitude des parasites générés dans la bande 150 kHz à 30 MHz, la séquence de variations {Fₖ ; k} peut être enregistrée dans une mémoire qui est lue séquentiellement, ou calculée et générée de manière continue.

Lorsque la variation de fréquence est aléatoire, le modulateur 6 comprend des moyens de génération de valeurs aléatoires, comme par exemple des moyens de détermination d'une valeur aléatoire sur la base d'un bruit blanc. Selon une variante, la variation de la fréquence peut être pseudo-aléatoire, le modulateur 6 comprenant des moyens de génération de valeurs pseudo-aléatoires utilisant par exemple une table comprenant des valeurs correspondant à un tirage aléatoire, puis en sélectionnant les valeurs parmi ce tirage, en particulier de façon cyclique. A titre d'exemple, on détermine trente-deux valeurs de manière aléatoire, puis on répète de manière cyclique cette séquence de trente-deux valeurs.

Dans un exemple de réalisation, on a utilisé le contacteur de la Figure 1, dans lequel on a monté un modulateur MLI à fréquence aléatoire modulée selon ce qui a été décrit ci-dessus à l'aide de la Figure 4. A la Figure 5, on a représenté une séquence de N créneaux, dont la période T est déterminée par la fréquence nominale Fch = 1/T déterminée par le circuit 20. Mais, aléatoirement, au moins certaines périodes de la séquence des N impulsions programmées sont de durées variables T+a ; T-b ; ... T, de sorte que l'on obtienne un étalement des parasites générés par le contacteur de l'invention. Dans un mode de réalisation, la durée de l'impulsion τ1, τ2, ..., τ, est égale à une valeur donnée. Dans un autre mode de réalisation, les variations +a, -b, ... de période (ou de fréquence) sont déterminées aléatoirement.

A la Figure 6, on a représenté un graphe des parasites générés par le schéma de commande des Figures 4 et 5. On a représenté le même gabarit limite 17, 18 de l'amplitude des parasites générés que celui de la Figure 3 qui porte les mêmes numéros de référence. L'amplitude des parasites a été mesurée dans la bande de fréquence de 100 kHz à 1 MHz et elle est tracée selon la courbe 19 qui passe entièrement sous le gabarit limite 17, 18.

Selon un autre mode de mise en oeuvre du procédé, il est possible de déterminer la variation de la période T des impulsions par une fonction déterministe, en particulier par une fonction linéaire ou linéaire par morceaux.

## Revendications

1. Procédé de commande d'un contacteur électromagnétique comprenant les étapes consistant à :
- alimenter un électroaimant 9 du contacteur par un signal d'alimentation à modulation de largeur d'impulsions (MLI) et présentant une fréquence nominale (Fch)
- faire varier la période (T) sur au moins une partie des impulsions de la modulation de façon à réduire les perturbations électromagnétiques conduites,
la variation de la période (T) étant choisie de façon à ce que la fréquence (F) du signal d'alimentation reste comprise dans une bande de fréquences donnée (BF) comportant la fréquence nominale (Fch).

2. Procédé selon la revendication 1, dans lequel on fait varier la largeur d'impulsion (τ) du signal d'alimentation.

3. Procédé selon l'une des revendications précédentes, dans lequel la variation de la période (T) des impulsions est déterminée de manière aléatoire.

4. Procédé selon la revendication 1, dans lequel la variation de la période (T) des impulsions est déterminée par une fonction déterministe.

5. Procédé selon la revendication 4, dans lequel la fonction est linéaire ou linéaire par morceaux.

6. Procédé selon la revendication 1, dans lequel la variation de la période (T) des impulsions est déterminée de manière pseudo-aléatoire.

7. Procédé selon l'une des revendications 4 à 6, dans lequel les variations de la période sont cycliques.

8. Procédé selon l'une des revendications précédentes dans lequel la variation de la période (T) des impulsions est appliquée de façon à :
- conserver une même période (T) sur une première pluralité de périodes ;
- modifier la valeur de la période (T) pour une seconde pluralité de périodes.

9. Procédé selon l'une des revendications précédentes dans lequel la variation de la période (T) des impulsions est appliquée de façon continue à chaque période.

10. Contacteur électromagnétique comportant un circuit de commande (5) agencé pour mettre en oeuvre les étapes d'un procédé selon l'une des revendications 1 à 9.

11. Contacteur selon la revendication 10, dans lequel le circuit de commande (5) comprend un dispositif de modulation MLI (6) agencé pour déterminer (22) une variation de la fréquence F à partir de la fréquence nominale (Fch).

12. Contacteur selon la revendication 11, dans lequel le modulateur MLI (6) comprend des moyens de génération de valeurs aléatoires ou pseudoaléatoires.
